# EUROPEAN PATENT APPLICATION

(11) **EP 4 826 115 A1**
(43) Date of publication of application: **21.10.2026**
(21) Application number: 24946148.4
(22) Date of filing: 29.10.2024
(51) Int. Cl.: C23C 16/02, C23C 16/26, H01B 13/00, H01B 5/00, H01B 7/42, H01H 11/04, H01H 1/02, H01H 1/027

(54) **COMPOSITE CONDUCTOR, PREPARATION METHOD THEREFOR, AND USE THEREOF**

(30) Priority: 03.07.2024 CN 202410886593
(71) Applicant: Zhejiang Chint Electrics Co., Ltd., Wenzhou, Zhejiang 325603 (CN); Shanghai Simbatt Energy Technology Co.,Ltd., Shanghai 201821 (CN)
(72) Inventor: MA, Yu, Wenzhou, Zhejiang 325603 (CN); LI, Mengshan, Wenzhou, Zhejiang 325603 (CN); AO, Dongyi, Wenzhou, Zhejiang 325603 (CN); DENG, Kewen, Wenzhou, Zhejiang 325603 (CN); WANG, Guorong, Wenzhou, Zhejiang 325603 (CN); XU, Zhenwei, Wenzhou, Zhejiang 325603 (CN)
(74) Representative: Berggren Oy
(86) International application number: PCT/CN2024/128214
(87) International publication number: WO 2026/007282

(57) **Abstract**

The present disclosure provides a composite conductor, a preparation method thereof, and an application thereof. The method for preparing a composite conductor includes: A) providing an initial metal substrate, and subjecting the initial metal substrate to oxidizing treatment to obtain a pre-oxidized metal substrate; B) subjecting the pre-oxidized metal substrate to annealing treatment in a reducing atmosphere, then placing the pre-oxidized metal substrate in a deposition chamber; and introducing a carbon source into the deposition chamber at a first temperature for a time period to deposit graphene; C) stopping introducing the carbon source, and introducing an oxygen-containing gas for a time period, followed by stopping introducing the oxygen-containing gas, and introducing the carbon source again to deposit graphene; repeating step C for n times to obtain the composite conductor, where n is an integer greater than or equal to 0. The composite conductor has high conductivity.

## Description

The present application claims priority to and the benefit of Chinese Patent Application No. 202410886593.X, filed with China National Intellectual Property Administration on July 3, 2024, entitled "Composite Conductor and Preparation Method Thereof and Application", the disclosure of which is incorporated herein by reference in its entirety.

### FIELD OF INVENTION

The present disclosure relates to the technical field of conductor materials, and in particular to a composite conductor, a preparation method thereof, and an application thereof.

### BACKGROUND OF INVENTION

Graphene has very high specific surface area, electron mobility, Young's modulus and thermal conductivity, and can be widely used in many fields such as lithium-ion batteries, transparent conductive films, supercapacitors, fuel cells, solar cells and hydrogen storage materials.

Metal conductors are widely used in electric power, transportation, industrial equipment, and electronic information fields due to their excellent electrical conductivity, thermal conductivity, and ductility. However, in recent years, higher requirements have been put forward for the electrical conductivity, thermal conductivity, and stability of metal conductors.

In related arts, graphene is usually combined with metal conductors, for example, copper powders are mixed with graphene powders, a graphene layer is deposited on a surface of a copper metal substrate by vapor deposition, so as to obtain composite conductors that combines both excellent properties of metals and graphene.

However, the conductivity of existing composite conductors is poor and needs to be further improved.

### SUMMARY OF INVENTION

In view of this, the present disclosure provides a composite conductor, aiming at improving the poor conductivity of existing composite conductors.

In a first aspect, embodiments of the present disclosure provide a method for preparing a composite conductor, which includes:
A. providing an initial metal substrate, and subjecting the initial metal substrate to oxidizing treatment to obtain a pre-oxidized metal substrate;
B. subjecting the pre-oxidized metal substrate to annealing treatment in a reducing atmosphere, followed by placing the pre-oxidized metal substrate in a deposition chamber; and introducing a carbon source into the deposition chamber at a first temperature for a period of time;
C. stopping introducing the carbon source, and introducing an oxygen-containing gas for a period of time, followed by stopping introducing the oxygen-containing gas, and introducing the carbon source; and
D. repeating step C for a total of n times to obtain the composite conductor, where n is an integer greater than or equal to 0.

In a second aspect, embodiments of the present disclosure provide a composite conductor. The composite conductor includes a metal substrate, a transition layer disposed on at least one surface of the metal substrate, and a graphene layer disposed on a surface of the transition layer away from the metal substrate, wherein the metal substrate includes the first metal, the transition layer includes a second metal and a first graphene, the graphene layer includes a second graphene, and an average sheet size of the first graphene is less than an average sheet size of the second graphene.

In a third aspect, embodiments of the present disclosure further provide an application of the composite conductor as a wire/cable or an electrical contact.

### BENEFICIAL EFFECTS OF THE INVENTION

The composite conductor prepared by the method described in the present disclosure has high electrical conductivity, thermal conductivity and mechanical strength.

### BRIEF DESCRIPTION OF DRAWINGS

In order to more clearly illustrate the technical solutions in embodiments of the present disclosure, hereinafter, the appended drawings used for describing the specific embodiments will be briefly introduced. Obviously, the appended drawings are only some embodiments of the present disclosure, and for a person skilled in the art, without expenditure of creative labor, other drawings can be derived on the basis of these appended drawings.
FIG. 1 is a schematic structural diagram of a composite conductor provided in embodiments of the present disclosure.
FIG. 2 is a schematic structural diagram of another composite conductor provided in embodiments of the present disclosure.
FIG. 3 is a flowchart of a method for preparing a composite conductor provided in embodiments of the present disclosure.
FIG. 4 is a schematic structural diagram of a pre-oxidized metal substrate provided in embodiments of the present disclosure.
FIG. 5 is a schematic structural diagram of another pre-oxidized metal substrate provided in embodiments of the present disclosure.
FIG. 6 is a schematic structural diagram of an initial metal substrate provided in embodiments of the present disclosure.
FIG. 7 is a schematic structural diagram of another initial metal substrate provided in embodiments of the present disclosure.
FIG. 8 is a schematic structural diagram of another initial metal substrate provided in embodiments of the present disclosure.
FIG. 9 is a schematic structural diagram of another initial metal substrate provided in embodiments of the present disclosure.

### DETAILED DESCRIPTION OF PREFERRED EMBODIMENTS

Hereinafter, technical solution in embodiments of the present disclosure will be clearly and completely described with reference to the drawings in embodiments of the present disclosure. Apparently, the described embodiments are only part of, but not all of, the embodiments of the present disclosure. All the other embodiments, obtained by a person with ordinary skill in the art based on the embodiments in the present disclosure without expenditure of creative labor, belong to the protection scope of the present disclosure. In addition, it should be understood that the specific embodiments described herein are intended only to illustrate and explain the present disclosure and are not intended to limit the present disclosure.

In the present disclosure, in the absence of contrary description, directional words such as "up" and "down" generally refer to the up and down in the actual use or working state of a device, and specifically the drawing direction in the accompanying drawings. While "inside" and "outside" are for profile of the device. In addition, in the description of the present disclosure, the terms "comprises", "comprising", "includes", "including", mean "including but not limited to". The terms "first", "second", "third" and the like are used merely as labels and do not impose numerical requirements or order of establishment.

In the present disclosure, "and/or" describes an association relationship between associated objects and indicates that three relationships may exist. For example, A and/or B may indicate the following three cases: Only A exists, both A and B exist, and only B exists. A and B may be singular or plural.

In the present disclosure, "at least one" refers to one or more, and "a plurality of/multiple" refers to two or more. "At least one", "at least one of the following" or similar expressions refer to any combination of these items, including any combination of single item (s) or a plurality of items. For example, "at least one of a, b or c" or "at least one of a, b and c" may all mean: a, b, c, a-b (that is, a and b), a-c, b-c, or a-b-c, wherein a, b and c may be single or a plurality respectively.

Throughout the present disclosure, various embodiments of this invention may be presented in a range format; it should be understood that the description in range format is merely for convenience and brevity and should not be construed as an inflexible limitation on the scope of the invention. Accordingly, the description of a range should be considered to have specifically disclosed all the possible sub ranges as well as individual numerical values within that range. For example, description of a range such as from 1 to 6 should be considered to have specifically disclosed sub-ranges such as from 1 to 3, from 1 to 4, from 1 to 5, from 2 to 4, from 2 to 6, from 3 to 6 etc., as well as individual numbers within that range, for example, 1, 2, 3, 4, 5, and 6. This applies regardless of the breadth of the range. In addition, whenever a numerical range is indicated herein, it is meant to include any cited numeral (fractional or integral) within the indicated range.

Currently, methods for preparing graphene mainly include mechanical exfoliation, oxidation-reduction method, chemical vapor deposition (CVD), and epitaxial growth.

Chemical vapor deposition is a method for growing graphene on a surface of a substrate after carbon atoms generated by pyrolysis of carbon sources interact with the substrate at high temperature. The production process of graphene by chemical vapor deposition based on metal (such as copper) is relatively well-established, and the grown graphene has a uniform number of layers and high quality, making it the most promising method to realize mass production at present.

Although the quality of graphene synthesized by CVD has improved through years of development, it still suffers from numerous structural defects. This results in significant differences in the physical and chemical properties compared to natural graphene (mechanically exfoliated graphene), limiting its applications in electrical and thermal conductivity. Furthermore, the extremely expensive preparation process prevents the widespread application of synthetic graphene. Therefore, breakthroughs in the preparation process are arguably one of the most important key factors for the application of graphene.

When preparing graphene by CVD, controlling the nucleation density and expanding the domain size of single-crystal graphene are common strategies. Focusing on active sites on copper foil to reduce the nucleation density can be divided into two methods: (i) reducing the number of active sites on copper by electropolishing and re-solidification; and (ii) passivating active sites with oxygen. Recent studies have shown that introducing oxygen into the growth environment plays a crucial role in the growth of graphene by CVD. With the participation of oxygen, micron-sized graphene sheets can be obtained on commercial copper foil. The addition of oxygen is a pretreatment method widely used in polycrystalline copper foil, which can reduce the surface roughness of the copper foil and remove impurities on the surface of the copper foil. Furthermore, the introduction of oxygen can not only passivate the nucleation sites on the surface of the copper foil but also help to reduce the dehydrogenation barrier of carbon sources, and increase the edge adhesion of carbon seeds, thereby significantly reducing the nucleation density and achieving ultrafast growth of large graphene single crystals.

In recent years, researchers have conducted extensive work on the introduction of oxygen into the growth environment of graphene, and different methods have been adopted in different studies. In a paper published by Li Na et al., Nanotechnology in 2020, the introduction of oxygen through pre-oxidation of copper foils before growth is mentioned as one of the most common methods. However, the oxygen content becomes insufficient as the growth time increases due to the consumption of reducing gases (hydrogen). In this regard, the work of Xu Xiaozhi et al. in LETTERS choses to put a compound that can stably release oxygen under the copper foil to realize a continuous supply of oxygen during the growth process, but this method inevitably reduces production efficiency and increases the production cost, making it unsuitable for mass production.

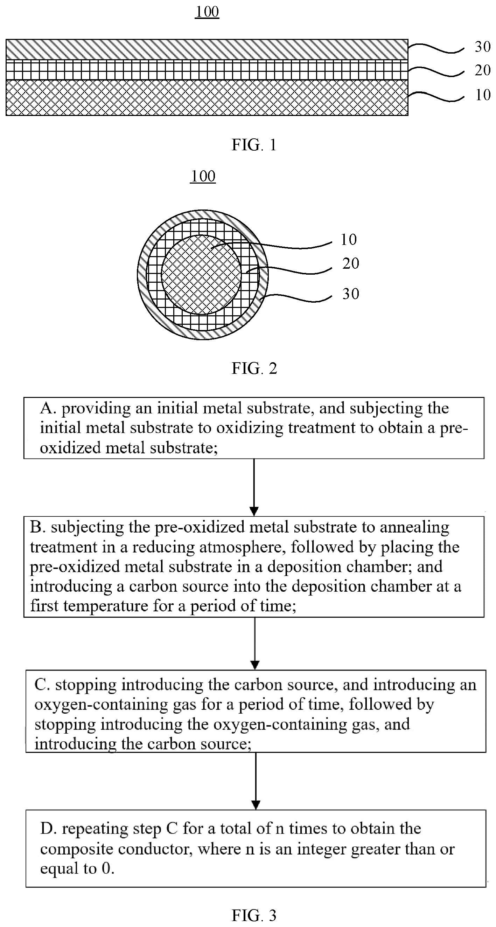

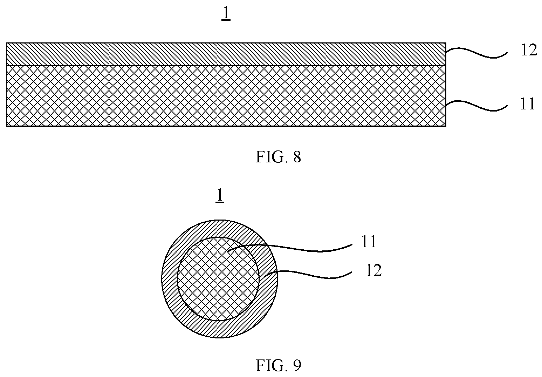

The technical solutions of the present disclosure are as follows:
Firstly, referring to FIGs. 1 to 9, embodiments of the present disclosure further provide a for preparing a composite conductor, which includes:
A. providing an initial metal substrate 1, and subjecting the initial metal substrate 1 to oxidizing treatment to obtain a pre-oxidized metal substrate 200;
B. subjecting the pre-oxidized metal substrate 200 to annealing treatment in a reducing atmosphere, followed by placing the pre-oxidized metal substrate 200 in a deposition chamber; and introducing a carbon source into the deposition chamber at a first temperature for a period of time;
C. stopping introducing the carbon source, and introducing an oxygen-containing gas for a period of time, followed by stopping introducing the oxygen-containing gas, and introducing the carbon source to deposit graphene; and
D. repeating step C for a total of n times to obtain the composite conductor 100, where n is an integer greater than or equal to 0.

It can be understood that when n is 0, it means that step C is not repeated.

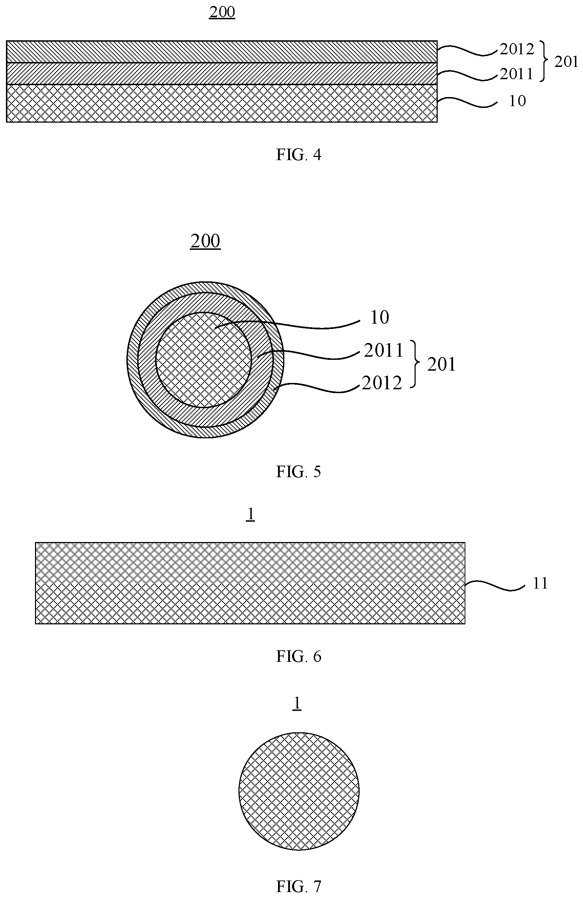

Referring to FIGs. 4 and 5, the pre-oxidized metal substrate 200 in step A includes a metal substrate 10 and a metal oxide layer 201 disposed on at least one surface of the metal substrate 10. The metal oxide layer 201 includes a first metal oxide layer 2011 bonded to the metal substrate 10 and a second metal oxide layer 2012 bonded to a surface of the first metal oxide layer 2011 away from the metal substrate 10. The metal substrate includes a first metal. The first metal oxide layer 2011 includes a metal oxide and a metal suboxide. The second metal oxide layer includes the metal oxide.

According to the method for preparing a composite conductor, when a vapor deposition gas is introduced into a deposition chamber at a first temperature, oxygen elements in the metal oxides and metal suboxides in the metal oxide layer 201 of the pre-oxidized metal substrate 200 are released under the action of the first temperature, and the metal oxides and metal suboxides are reduced. Taking copper as an example, copper oxide and cuprous oxide undergo the following reactions at a high temperature: CuO→CuO₂, CuO₂→Cu, thus releasing oxygen elements. The presence of oxygen can effectively reduce the energy barrier of the carbon precursor pyrolysis reaction and improve the pyrolysis efficiency, so as to obtain fully pyrolyzed carbon species (CH₄+O→CH₃.; CH₃+O CH₂.; CH₂+O→CH.; CH₂+O→C.), thereby increasing the deposition rate of graphene. After the metals are oxidized into metal oxides by pre-oxidation treatment, the surface roughness will be increased, thus increasing the number of theoretical nucleation sites. However, oxygen is released at the first temperature. The released oxygen can passivate the copper on the surface of the pre-oxidized metal substrate 200, so as to prevent carbon species from nucleating at some theoretical nucleation sites, which can not only reduce the activity of copper in the oxygen-containing region of the substrate, but also reduce the number of actual nucleation sites, thereby promoting the formation of graphene with large grain size. In this way, pre-oxidation treatment can not only increase the deposition rate but also facilitate the formation of graphene with large grain size.

Furthermore, the metal oxides and metal suboxides in the pre-oxidized metal substrate 200 are reduced to the second metals at the first temperature, and water or carbon dioxide is generated simultaneously. Water or carbon dioxide can be discharged with the gas phase deposition gas without introducing new impurities into the composite conductor 100.

Furthermore, the change from metal oxides to metal suboxides and then back to metals during the reaction at the first temperature, for example, the change from copper oxide to cuprous oxide and then to copper, in which the metals change to metal oxides, leads to an increase in the surface roughness of the substrate. The conversion of metal oxides into metal suboxides and metal elements can significantly reduce the surface roughness of the substrate, and further improve the flatness compared with the untreated substrate surface, thereby further reducing the number of nucleation sites. According to the method, during the deposition process of graphene, part of carbon atoms pyrolyzed at a high temperature will be directly deposited on the surface of the metal oxide layer 201 of the pre-oxidized metal matrix 200 to form a second graphene with large grain size, thus obtaining the graphene layer 30. Furthermore, since oxygen in the metal oxides and metal suboxides will detach at high temperatures to form defective metals, part of carbon atoms pyrolyzed at a high temperature will be deposited at the defects of these metals to form first graphene with small grains, thereby transforming the metal oxide layer 201 into a transition layer 20 containing a second metal and the first graphene with small grain size.

According to the method described in the present disclosure, by subjecting the initial metal substrate 1 to oxidizing treatment, the formation of first graphene with large grain size can be effectively promoted, and the pyrolysis of the carbon sources can be promoted as well. However, during the process of graphene deposition, the oxygen content in the pre-oxidized metal substrate is consumed (e.g., consumed by reaction with reducing gases) as graphene is deposited, resulting in insufficient oxygen supply. However, in the present disclosure, after introducing the carbon sources for a period of time, the introduction of the carbon sources will be stopped, and oxygen gas will be introduced instead, in this way, the metals can be oxidized again to form metal oxides and/or metal suboxides, thus realizing oxygen replenishment and reducing the number of active sites on the surface of the substrate. Thus, after oxygen is supplemented, carbon sources are introduced again for graphene deposition, which is beneficial to continue forming graphene with a large grain size. As a result, the average grain size of the second graphene in the graphene layer 30 of the obtained composite conductor 100 is larger, and the uniformity of the grain size of the second graphene is higher. Consequently, the obtained composite conductor 100 has higher electrical conductivity, thermal conductivity, and mechanical strength.

Furthermore, the pre-oxidized metal substrate obtained by pre-oxidation treatment has a high oxygen content on its surface, leading to an increase in surface roughness. However, according to the present disclosure, the pre-oxidized metal substrate 200 is subjected to annealing treatment in a reducing atmosphere, which can reduce the oxygen content to some extent in the pre-oxidized metal substrate 200. While it seems contradictory to use the process of oxidation first and then reduction annealing, it is in fact to control the oxygen content in the substrate more accurately before growth, which is beneficial to subsequent graphene deposition. On one hand, subjecting the pre-oxidized metal substrate to annealing treatment in a reducing atmosphere can reduce part of the metal oxides in the second metal oxide layer 2012 of the pre-oxidized metal substrate 200 to generate elemental metals and metal suboxides. When graphene is deposited on the surface of the pre-oxidized metal substrate 200, the metal suboxides can promote pyrolysis of carbon sources, while the elemental metals, combined with the released oxygen, can not only effectively promote the pyrolysis of the carbon sources, but also help to generate graphene with a large grain size. On the other hand, the material of the second metal oxide layer 2012 of the pre-oxidized metal substrate 200 is mainly metal oxide, which will lead to a high surface roughness of the pre-oxidized metal substrate 200. High surface roughness will lead to a surge in the number of theoretical nucleation sites. Further, subjecting the pre-oxidized metal substrate 200 to annealing treatment in a reducing atmosphere can transform at least part of the metal oxides in the second metal oxide layer 2012 into metal suboxides. In this way, surface roughness of the pre-oxidized metal substrate 200 can be reduced, thus effectively avoiding the surge in the number of theoretical nucleation sites, and more effectively reducing the number of actual nucleation sites on the surface of the pre-oxidized metal substrate 200. Furthermore, the oxygen content in metal oxides is higher than that in metal suboxides. More oxygen is released at the first temperature, and more oxygen reacts with free carbon to generate carbon dioxide and/or carbon monoxide. In addition, the released oxygen can also react with surrounding deposited graphene to etch it, which to some extent hinders the formation of graphene, resulting in poor uniformity and density of the graphene layer 30, thus affecting the conductivity and hardness of the obtained composite conductor. Annealing treatment in a reducing atmosphere reduces metal oxides to metal suboxides, which can reduce the oxygen content to a certain extent, thereby effectively improving the conductivity and hardness of the prepared composite conductor.

Furthermore, the first metal oxide layer 2011 of the pre-oxidized metal substrate 200 includes metal oxides and metal suboxides. Thus, compared to a first metal oxide layer that is entirely composed of metal oxides, it can effectively reduce the number of active sites on the surface of the pre-oxidized metal substrate 200, promote the formation of graphene with a large grain size, and promote the pyrolysis of carbon sources.

In step A:
The material of the initial metal substrate 1 includes one or more of a metal element and an alloy, the metal element includes one or more of Cu and Al, and the alloy includes one or more of a copper-nickel alloy, a copper-silver alloy, and a copper-zinc alloy.

The initial metal substrate 1 includes a metal particle, a metal foil, or a metal wire.

Referring to FIGs. 6 and 7, in some embodiments, the initial metal substrate 1 includes a first initial metal substrate 11. The material of the first initial metal substrate 11 includes one or more of a metal element and an alloy. The metal element includes one or more of Cu and Al. The alloy includes one or more of a copper-nickel alloy, a copper-silver alloy, and a copper-zinc alloy. At this time, the pre-oxidation treatment oxidizes the surface of the first initial metal substrate 11 to obtain the metal oxide layer 201, and the unoxidized part is used as the metal substrate 10, thus obtaining the pre-oxidized metal substrate 200. At this time, the metals in the metal oxide layer 201 are of the same type as the metals in the metal substrate 10. Correspondingly, during the process of graphene deposition, the type of the second metals in the formed transition layer 20 is the same as that of the first metals in the metal substrate 10.

Referring to FIGs, 8 and 9, in other embodiments, the initial metal substrate 1 includes the first initial metal substrate 11 and a second initial metal substrate 12 disposed on the surface of the first initial metal substrate 11. The material of each of the first initial metal substrate 11 and the second initial metal substrate 12 includes one or more of a metal element and an alloy. The metal element includes one or more of Cu and Al. The alloy includes one or more of a copper-nickel alloy, a copper-silver alloy, and a copper-zinc alloy. It can be understood that the material of the first initial metal substrate is same as or different from that of the second initial metal substrate. During the pre-oxidation treatment, the second initial metal substrate 12 is oxidized to obtain the metal oxide layer 201, and the first initial metal substrate 11 becomes the metal substrate 10, thus obtaining the pre-oxidized metal substrate 200. At this time, the metals in the metal oxide layer 201 can be the same as or different from the metals in the metal substrate 10. Correspondingly, during the process of graphene deposition, the type of the second metals in the formed transition layer 20 can be the same as or different from that of the first metals in the metal substrate 10.

In some embodiments, the thickness of the second initial metal substrate 12 ranges from 0.1 µm to 1 µm.

In some embodiments, subjecting the initial metal substrate to oxidizing treatment includes a step of placing the initial metal substrate in an oxygen-containing atmosphere, and performing heat-treating at a second temperature for a period of time t1.

In some embodiments, the oxygen-containing atmosphere includes, but is not limited to, air, oxygen, or a first inert gas containing oxygen.

In some embodiments, the first inert gas includes, but is not limited to, one or more of nitrogen, helium, argon, and xenon.

In some embodiments, the second temperature ranges from 60°C to 150°C, for example, it may be 60°C, 70°C, 80°C, 90°C, 100°C, 110°C, 120°C, 130°C, 140°C, 150°C, etc. The period of time t1 ranges from 1 h to 5 h, for example, it may be 1 h, 1.5 h, 2 h, 2.5 h, 3 h, 3.5 h, 4 h, 4.5 h, 5 h, etc. Within the temperature range and time range, the prepared pre-oxidized metal substrate 200 can have a metal oxide layer 201 with a specific thickness ratio. In this way, the strength and overall density of the pre-oxidized metal substrate cannot be changed due to oxidation, and the number of active sites can be effectively suppressed in the early stage of vapor deposition, especially in the early stage of graphene lattice formation, and sufficient oxygen can be precipitated to promote pyrolysis of methane to form carbon atoms.

Furthermore, the second temperature is low and the oxidation time is long, which can achieve low-temperature and long-time oxidation, so that on the one hand, low-temperature oxidation is beneficial to the formation of cuprous oxide as the main component, while long-time oxidation can increase the degree of oxidation of the initial metal substrate 1, on the other hand, low-temperature oxidation can allow for greater depth of oxygen action in copper foil under the same oxidation conditions, and the oxygen element inside the metal oxides and/or metal suboxides with greater depth of oxygen action is difficult to be completely removed unless the reduction time is long enough. This is conducive to the long-term and continuous release of oxygen, which promotes the continuous formation of second graphene with a large grain size.

In some embodiments, in the pre-oxidized metal substrate 200, the metal oxide layer 201 can cover 99.6% to 100% of the surface of the metal substrate 10. In this way, the number of active sites on the surface of the pre-oxidized metal substrate 200 can be reduced, which is beneficial for having a larger average grain size of the second graphene in the graphene layer 30 of the prepared composite conductor 100. Consequently, the prepared composite conductor 100 has higher electrical conductivity, thermal conductivity, and mechanical strength.

In some embodiments, the mass ratio of metal oxides to metal suboxides in the first metal oxide layer 2011 ranges from (0.001 to 0.05):1, for example, it may be 0.001:1, 0.005:1, 0.01:1, 0.015:1, 0.02:1, 0.025:1, 0.03:1, 0.035:1, 0.04:1, 0.045:1, 0.05:1, etc. Within this ratio range, it is advantageous for graphene in the graphene layer 30 of the prepared composite conductor 100 to have a larger average grain size, so that the prepared composite conductor 100 has higher electrical conductivity, thermal conductivity, and mechanical strength.

In some embodiments, the metal oxide includes, but is not limited to, one or more of copper oxide, aluminum oxide, nickel oxide, nickel tetroxide, nickel trioxide, silver oxide, and zinc oxide.

In some embodiments, the metal suboxide includes, but is not limited to, cuprous oxide (Cu₂O).

In some embodiments, the ratio of the thickness of the first metal oxide layer 2011 to the thickness of the second metal oxide layer 2012 is in a range of (0.1 to 9):1, for example, it may be 0.1:1, 0.5:1, 1:1, 1.5:1, 2:1, 2.5:1, 3:1, 3.5:1, 4:1, 4.5:1, 5:1, 5.5:1, 6:1, 6.5:1, 7:1, 7.5:1, 8:1, 8.5:1, 9:1, etc.

In some embodiments, when the metal substrate is a metal foil, the thickness of the metal substrate 10 ranges from 25 µm to 50 µm, for example, it may be 25 µm, 28 µm, 30 µm, 32 µm, 33 µm, 35 µm, 36 µm, 38 µm, 40 µm, 42 µm, 43 µm, 44 µm, 45 µm, 46 µm, 48 µm, 50 µm, etc.

In some embodiments, the thickness of the first metal oxide layer 2011 ranges from 0.06 µm to 0.45 µm, for example, it may be 0.06 µm, 0.08 µm, 0.1 µm, 0.15 µm, 0.2 µm, 0.25 µm, 0.3 µm, 0.35 µm, 0.4 µm, 0.45 µm, etc.

In some embodiments, the thickness of the second metal oxide layer 2012 ranges from 0.05 µm to 0.6 µm, for example, it may be 0.05 µm, 0.08 µm, 0.1 µm, 0.15 µm, 0.2 µm, 0.25 µm, 0.3 µm, 0.35 µm, 0.4 µm, 0.45 µm, 0.5 µm, 0.55 µm, 0.6 µm, etc.

In some embodiments, the thickness of the metal oxide layer 201 ranges from 0.1 µm to 1 µm, for example, it may be 0.1 µm, 0.2 µm, 0.3 µm, 0.4 µm, 0.5 µm, 0.6 µm, 0.7 µm, 0.8 µm, 0.9 µm, 1 µm, etc.

Within the thickness range of the first metal oxide layer 2011, the second metal oxide layer 2012, and the metal oxide layer 201, during the subsequent process of graphene deposition, the oxygen element in the metal oxide layer 201 can still be kept at a sufficient concentration even being subjected to annealing in a reducing gas, thus promoting the growth of limonene.

In some embodiments, after obtaining the pre-oxidized metal substrate 200, the method further includes: subjecting the pre-oxidized metal substrate 200 to oxygen-reduced and water-reduced treatment.

Due to the existence of oxygen and water vapor physically adsorbed on the surface of the pre-oxidized metal substrate 200, the oxygen and water vapor will form chemical corrosion on the surface of the pre-oxidized metal substrate 200, making it difficult to control the degree of oxidation of the pre-oxidized metal substrate 200, thus affecting the reproducibility of the preparation of composite conductor under the same parameters. The oxygen-reduced and water-reduced treatment can effectively remove the oxygen and water vapor, especially water vapor that are physically adsorbed on the surface of the pre-oxidized metal substrate 200, thereby improving the reproducibility of the preparation of composite conductor.

In some embodiments, the oxygen-reduced and water-reduced treatment includes a step of performing vacuum treatment on the pre-oxidized metal substrate 200.

In some embodiments, the step of performing vacuum treatment on the pre-oxidized metal substrate 200 includes a step of placing the pre-oxidized metal substrate in a sealed environment, vacuumizing until a vacuum degree is less than 0.1 Pa, and keeping for a period of time t3.

In some embodiments, the period of time t3 ranges from 2 min to 10 min, for example, it may be 2 min, 3 min, 4 min, 5 min, 6 min, 7 min, 8 min, 9 min, 10 min, etc. Within this range, it is beneficial to quickly and effectively remove oxygen and water vapor that are physically adsorbed on the surface of the pre-oxidized metal substrate 200.

In some embodiments, the reducing gas in the reducing atmosphere includes, but is not limited to, hydrogen.

In some embodiments, the reducing atmosphere further includes a second inert gas, which includes, but is not limited to, one or more of nitrogen, helium, argon, and xenon.

In some embodiments, the volume ratio of the second inert gas to the reducing gas ranges from (0.5 to 2):1, for example, it may be 0.5:1, 0.8:1, 1:1, 1.2:1, 1.3:1, 1.5:1, 1.6:1, 1.8:1, 2:1, etc. Within this range, the pre-oxidized metal substrate 200 can be appropriately reduced, which is beneficial for preparing a second graphene with a large grain size, thus beneficial for preparing a graphene layer 30 with good crystallinity and film-forming properties, and further beneficial for preparing a composite conductor 100 with good electrical conductivity, thermal conductivity, and mechanical strength.

In some embodiments, the temperature for subjecting the pre-oxidized metal substrate 200 to annealing treatment ranges from 1000°C to 1055°C, for example, it may be 1000°C, 1005°C, 1010°C, 1015°C, 1020°C, 1025°C, 1030°C, 1035°C, 1040°C, 1045°C, 1050°C, 1055°C, etc.; the time for performing annealing treatment ranges from 30 min to 40 min, for example, it may be 30 min, 35 min, 40 min, etc. Within the temperature range and time range, the pre-oxidized metal substrate 200 can be appropriately reduced, which is beneficial for preparing a second graphene with a large grain size, and beneficial for preparing a graphene layer 30 with good crystallinity and film-forming properties, and further beneficial for preparing a composite conductor 100 with good electrical conductivity, thermal conductivity and mechanical strength.

In some embodiments, the oxygen content in the pre-oxidized metal substrate 200 before being subjected to annealing treatment in the reducing atmosphere ranges from 150 ppm to 300 ppm, for example, it may be 150 ppm, 180 ppm, 200 ppm, 230 ppm, 250 ppm, 280 ppm, 300 ppm, etc.

In some embodiments, the oxygen content in the pre-oxidized metal substrate 200 after being subjected to annealing treatment in the reducing atmosphere ranges from 20 ppm to 100 ppm, for example, it may be 20 ppm, 30 ppm, 40 ppm, 50 ppm, 60 ppm, 70 ppm, 80 ppm, 90 ppm, 100 ppm, etc.

In step B:
The first temperature range ranges from 1000°C to 1055°C, for example, it may be 1000°C, 1005°C, 1010°C, 1015°C, 1020°C, 1025°C, 1030°C, 1035°C, 1040°C, 1045°C, 1050°C, 1055°C, etc. Within this temperature range, it is beneficial for depositing to obtain graphene with good crystallinity and a large grain size.

The carbon source includes, but is not limited to, one or more of the carbon source gases known for preparing graphene by vapor deposition, such as methane, natural gas, acetylene, and propane.

The gas flow rate of the carbon source ranges from 3 sccm to 40 sccm, for example, it may be 3 sccm, 5 sccm, 8 sccm, 10 sccm, 15 sccm, 20 sccm, 25 sccm, 30 sccm, 35 sccm, 40 sccm, etc.

A protective gas is introduced simultaneously when introducing carbon sources. The protective gas includes, but is not limited to, one or more of nitrogen, helium, argon, and xenon.

In some embodiments, the flow rate of the protective gas ranges from 0 to 1000 sccm, for example, it may be 10 sccm, 50 sccm, 100 sccm, 150 sccm, 200 sccm, 250 sccm, 300 sccm, 500 sccm, 600 sccm, 800 sccm, 900 sccm, 1000 sccm, etc. It can be understood that when the flow rate of the protective gas is 0, it means that no protective gas has been introduced.

It can be understood that when introduction of carbon sources is stopped, the introduction of protective gas is also stopped.

In some embodiments, a reducing gas is introduced simultaneously when introducing the carbon sources. The reducing gas can be a known reducing gas used for preparing graphene by vapor deposition, for example, it includes but is not limited to hydrogen.

In some embodiments, the flow rate of the reducing gas ranges from 5 sccm to 500 sccm, for example, it may be 5 sccm, 10 sccm, 50 sccm, 100 sccm, 150 sccm, 200 sccm, 250 sccm, 300 sccm, 350 sccm, 400 sccm, 450 sccm, 500 sccm, etc.

It can be understood that when introduction of the carbon sources is stopped, the introduction of the reducing gas is stopped as well.

In step C:
The oxygen-containing gas includes, but is not limited to, air, oxygen, and a first inert gas containing oxygen. The first inert gas is as described above.

In some embodiments, the flow rate of the oxygen-containing gas ranges from 3 sccm to 40 sccm, for example, it may be 3 sccm, 5 sccm, 8 sccm, 10 sccm, 15 sccm, 20 sccm, 25 sccm, 30 sccm, 35 sccm, 40 sccm, etc. Within this flow rate range, it is beneficial to ensure an appropriate oxygen content in the pre-oxidized metal substrate.

It can be understood that in steps B to D, the type of oxygen-containing gas introduced each time may be the same or different, the type of carbon source introduced each time may be the same or different, the type of reducing gas introduced each time may be the same or different, and the type of protective gas introduced each time may be the same or different.

It can be understood that in steps B to D, the flow rate of the oxygen-containing gas introduced each time may be the same or different, the flow rate of the carbon sources introduced each time may be the same or different, the flow rate of the reducing gas introduced each time may be the same or different, and the flow rate of the protective gas introduced each time may be the same or different.

In the preparation method, the total time for introducing the carbon sources ranges from 60 min to 90 min, for example, it may be 60 min, 65 min, 70 min, 75 min, 80 min, 85 min, 90 min, etc.

In steps B to D, the time for introducing the carbon sources each time can be the same or different.

In some embodiments, the time for introducing the carbon sources each time is the same, which ranges from 15 min to 30 min, for example, it may be 15 min, 20 min, 25 min, 30 min, etc.

In other embodiments, the time for introducing the carbon sources each time is different, and the time for introducing the carbon sources for a previous time is (1/3 to 1/2) times that for a next time. For example, the time for introducing the carbon source for the first time is h₁, the time for introducing the carbon source for the second time is h₂=(1/3~1/2)×h₁, and the time for introducing the carbon source for the third time is h₃=(1/3~1/2)×h₂, and so on. In some embodiments, the time for introducing the carbon source for the first time is 30 to 40 min.

In some embodiments, after each introduction of oxygen-containing gas, the oxygen content in the pre-oxidized metal substrate can reach a range from 20 ppm to 100 ppm, for example, 20 ppm, 30 ppm, 40 ppm, 50 ppm, 60 ppm, 70 ppm, 80 ppm, 90 ppm, 100 ppm, etc.

In some embodiments, before introducing carbon sources into the deposition chamber, the method further includes pre-pyrolyzing the carbon sources to release hydrogen atoms from the carbon sources and form free carbon.

The pre-pyrolysis treatment is beneficial for effectively reducing the content of carbon impurities (i.e., insufficiently pyrolyzed substances) in the graphene layer during subsequent graphene deposition, so that the prepared graphene has a larger crystal domain and fewer grain boundaries, which is conducive to preparing a composite conductor 100 with good electrical and thermal conductivity.

In some embodiments, the pre-pyrolysis treatment is performed in a pyrolysis chamber.

In some embodiments, the pre-pyrolysis treatment is performed at a temperature ranging from 850°C to 1050°C, for example, 850°C, 860°C, 880°C, 900°C, 920°C, 930°C, 950°C, 960°C, 980°C, 1000°C, 1020°C, 1030°C, 1050°C, etc.

In some embodiments, the pre-pyrolysis treatment is performed in a medium such as a metal oxide, including but not limited to copper oxide.

In some embodiments, the medium may be a film, a plate, or granules.

According to the preparation method in the present disclosure, by performing intermittent oxidation on the initial metal substrate 1, oxygen can be replenished in time when the oxygen content in the initial metal substrate 1 is low, leading to an increase in active sites and preventing graphene with a large grain size being continuously generated. In this way, on the one hand, it can be ensured that most of the graphene produced during the whole deposition process can have a large sheet size, thereby improving the conductivity, thermal conductivity, and mechanical properties of the prepared composite conductor; on the other hand, it can also promote the pyrolysis of the carbon sources, thus accelerating the rapid growth of graphene. Furthermore, the method in the present disclosure has low production costs and is suitable for large-scale mass production.

In a second aspect, please refer to FIGs. 1 and 2, embodiments of the present disclosure provide a composite conductor 100. The composite conductor 100 includes a metal substrate 10, a transition layer 20 located on at least one surface of the metal substrate 10, and a graphene layer 30 located on a surface of the transition layer 20 away from the metal substrate 10. The metal substrate 10 includes a first metal. The transition layer 20 includes a second metal and a first graphene. The graphene layer 30 includes a second graphene.

The first metal includes, but is not limited to, one or more of a metal element and an alloy. The metal element includes, but is not limited to, one or more of Cu and Al. The alloy includes, but is not limited to, one or more of a copper-nickel alloy, a copper-silver alloy, and a copper-zinc alloy.

The second metal includes, but is not limited to, one or more of a metal element and an alloy. The metal element includes, but is not limited to, one or more of Cu and Al. The alloys includes, but is not limited to, one or more of a copper-nickel alloy, a copper-silver alloy, and a copper-zinc alloy.

It can be understood that the first metal may be the same as or different from the second metal. In at least one embodiment, the first metal is the same as the second metal. Further, in at least some embodiments, both the first metal and the second metal are Cu.

The average sheet size of the first graphene is less than the average sheet size of the second graphene.

In some embodiments, the average sheet size of the first graphene ranges from 0.01 µm to 0.1 µm, for example, 0.01 µm, 0.02 µm, 0.03 µm, 0.04 µm, 0.05 µm, 0.06 µm, 0.07 µm, 0.08 µm, 0.09 µm, 0.1 µm, etc.

In some embodiments, the average sheet size of the second graphene ranges from 2 µm to 6 µm, for example, 2 µm, 2.1 µm, 2.2 µm, 2.3 µm, 2.4 µm, 2.5 µm, 2.6 µm, 2.7 µm, 2.8 µm, 2.9 µm, 3 µm, 3.2 µm, 3.5 µm, 3.6 µm, 3.8 µm, 4 µm, 4.2 µm, 4.5 µm, 4.6 µm, 4.8 µm, 5 µm, 5.3 µm, 5.5 µm, 5.8 µm, 6 µm, etc.

The second graphene in graphene layer 30 of the composite conductor 100 as described in the present disclosure has a large sheet size, i.e., a larger grain size, which enables the composite conductor 100 to have high electrical conductivity, thermal conductivity and mechanical strength.

Referring to FIG. 1, in some embodiments, the metal substrate 10 is a metal foil. Referring to FIG. 2, in other embodiments, the metal substrate 10 is made of metal particles. In other embodiments, the metal substrate 10 may also be a metal wire, and the cross-sectional view of which can be seen in FIG. 2.

In some embodiments, the mass ratio of the second metal to the first graphene in the transition layer 20 is in a range of (0.5 to 50):1, for example, it may be 0.5:1, 1:1, 1.5:1, 2:1, 2.5:1, 3:1, 3.5:1, 4:1, 4.5:1, 5:1, etc. Within this ratio range, it is beneficial to make the composite conductor 100 to have high electrical conductivity, thermal conductivity, and mechanical strength.

In some embodiments, the thickness of the transition layer 20 ranges from 0.1 to 1 µm, for example, it may be 0.1 µm, 0.2 µm, 0.3 µm, 0.4 µm, 0.5 µm, 0.6 µm, 0.7 µm, 0.8 µm, 0.9 µm, 1 µm, etc.

In some embodiments, when the metal substrate 10 is a metal foil, the thickness of the metal foil ranges from 25 to 50 µm, for example, it may be 25 µm, 28 µm, 30 µm, 32 µm, 33 µm, 35 µm, 36 µm, 38 µm, 40 µm, 42 µm, 43 µm, 44 µm, 45 µm, 46 µm, 48 µm, 50 µm, etc.

In some embodiments, the thickness of the graphene layer 30 ranges from 0.335 to 3 nm, for example, it may be 0.335 nm, 0.4 nm, 0.5 nm, 0.8 nm, 1 nm, 1.2 nm, 1.3 nm, 1.5 nm, 1.6 nm, 1.8 nm, 2 nm, 2.1 nm, 2.3 nm, 2.5 nm, 2.6 nm, 2.8 nm, 3 nm, etc.

Within the thickness ranges of the transition layer 20 and the graphene layer 30, the composite conductor 100 can have high electrical conductivity, thermal conductivity and mechanical strength.

In some embodiments, the conductivity of the composite conductor 100 ranges from 87% to 121% (IACS, International Annealed Copper Standard), for example, it may be 87%, 90%, 92%, 93%, 95%, 96%, 98%, 100%, 102%, 103%, 105%, 106%, 107%, etc. It can be seen that the composite conductor 100 described in the present disclosure has a high conductivity, reaching up to 121%.

The composite conductor 100 described in the present disclosure includes a metal substrate 10, a transition layer 20, and a graphene layer 30. The transition layer 20 includes both metals and graphene, which effectively enhances the bonding force between the metal substrate 10 and the graphene layer 30, thereby improving the conductivity, thermal conductivity, and mechanical strength of the composite conductor 100. Furthermore, the graphene in the graphene layer 30 has a large grain size and high uniformity, which contributes to the high conductivity, thermal conductivity, and mechanical strength of the composite conductor 100.

In a third aspect, the present disclosure further provides an application of the composite conductor 100, which can be used in any device that requires electrical conductivity and/or thermal conductivity, such as wires and cables, electrical contacts, and other conductors.

The following examples will be used to illustrate the present disclosure. The following examples are only part of the examples of the present disclosure and do not limit the present disclosure. The raw materials used in the following examples, unless otherwise specified, are all commercially available products.

### Example 1

Step A: exposing a copper foil to air, and treating it at 105°C for 3 h by using an electric heating plate to obtain a pre-oxidized copper foil. Followed by placing the pre-oxidized copper foil in a quartz boat, pushing it into a CVD tube furnace and vacuum pumping to 0.1 Pa and keeping for 2 min; then performing reduction annealing at 1025°C for 35 min in a mixed gas atmosphere of Ar₂ and H₂ (with a volume ratio of 2:1).

The pre-oxidized copper foil includes a metal substrate and a metal oxide layer located on a surface of the metal substrate. The metal oxide layer includes a first metal oxide layer bonded to the metal substrate and a second metal oxide layer bonded to the surface of the first metal oxide layer away from the metal substrate. The metal substrate includes copper. The first metal oxide layer includes copper oxide and cuprous oxide. The second metal oxide layer includes copper oxide. The thickness of the metal substrate is 30 µm. The thickness of the first metal oxide layer is 0.25 µm. The thickness of the second metal oxide layer is 0.32µm. The mass ratio of copper oxide to cuprous oxide in the first metal oxide layer is 0.03:1.

The oxygen content in the pre-oxidized copper foil obtained after treating by using an electric heating plate at 105°C for 3 h is about 225 ppm. The oxygen content in the pre-oxidized copper foil after reduction annealing is about 60 ppm.

Step B: then introducing CH₄ gas (with a flow rate of 20 sccm) into the system for 40 min.

Step C: stopping introducing CH₄ gas, and then introducing oxygen (with a flow rate of 20 sccm) into the tube furnace for 2 min, so that the oxygen element in the pre-oxidized metal substrate can be filled to about 60 ppm again to realize secondary oxygenation; then, stopping introducing oxygen, and introducing CH₄ gas (with a flow rate of 22 sccm) into the tube furnace for 20 min; followed by stopping introducing CH₄ gas, and opening the cover the furnace to allow it to be cooled naturally to room temperature, thus obtaining the composite conductor.

The composite conductor of this example includes a copper layer, a transition layer located on one surface of the copper layer, and a graphene layer located on the surface of the transition layer away from the copper layer. The transition layer includes copper and a first graphene, and the graphene layer includes a second graphene.

### Example 2

This example is basically the same as Example 1, and the differences lie in that:
In step A of this example, the copper foil is treated at 60°C for 1 h by using an electric heating plate. At this time, the oxygen content in the copper foil is about 150 ppm, the thickness of the first metal oxide layer is 0.06 µm, the thickness of the second metal oxide layer is 0.05 µm, the mass ratio of copper oxide to cuprous oxide in the first metal oxide layer is 0.001:1, and the oxygen content in the pre-oxidized copper foil after reduction annealing is about 20 ppm.

In step C of this example, oxygen (with a flow rate of 3 sccm) is introduced into the tubular furnace for 2 min, so that the oxygen element in the pre-oxidized metal substrate can be filled to about 20 ppm again.

### Example 3

This example is basically the same as Example 1, and the differences lie in that:
In step A of this example, the copper foil is treated at 150°C for 3 h by using an electric heating plate. At this time, the oxygen content in the copper foil is about 300 ppm, the thickness of the first metal oxide layer is 0.45 µm, the thickness of the second metal oxide layer is 0.6 µm, the mass ratio of copper oxide to cuprous oxide in the first metal oxide layer is 0.05:1, and the oxygen content in the pre-oxidized copper foil after reduction annealing is about 100 ppm.

In step C of this example, oxygen (with a flow rate of 40 sccm) is introduced into the tubular furnace for 2 min, so that the oxygen element in the pre-oxidized metal substrate can be filled to about 100 ppm again.

### Example 4

This example is basically the same as Example 1, and the differences lie in that:
In step B of this example, annealing is performed at 1000°C for 60 min, after annealing is completed, the oxygen content in the pre-oxidized copper foil is about 70 ppm.

In step C of this example, oxygen (with a flow rate of 15 sccm) is introduced into the tube furnace for 2 min, so that the oxygen element in the pre-oxidized metal substrate can be filled to about 70 ppm again.

### Example 5

This example is basically the same as Example 1, and the differences lie in that:
In step B of this example, annealing is performed at at 1055°C for 60 min. After annealing is completed, the oxygen content in the pre-oxidized copper foil is about 40 ppm.

In step C of this example, oxygen (with a flow rate of 25 sccm) is introduced into the tube furnace for 2 min, so that the oxygen element in the pre-oxidized metal substrate can be filled to about 40 ppm again.

### Example 6

This example is basically the same as Example 1, and the differences lie in that: the flow rate of CH₄ gas in steps B and C of this example is 3 sccm.

### Example 7

This example is basically the same as Example 1, and the differences lie in that: the flow rate of CH₄ gas in steps B and C of this example is 40 sccm.

### Example 8

This example is basically the same as Example 1, and the differences lie in that: after step C, it also includes:
Step D: repeating step C once. When repeating the step C, the CH₄ gas is introduced into the tubular furnace for 10 min.

### Example 9

This example is basically the same as Example 1, and the differences lie in that: after step C, it also includes:
Step D: repeating step C for a total of three times. The time for introducing CH₄ gas into the tubular furnace during the three times is 10 min, 5 min, and 2.5 min, respectively.

### Example 10

This example is basically the same as Example 1, and the differences lie in that: the time for introducing CH₄ gas into the tubular furnace in both steps B and C of this example is 30 min.

### Example 11

This example is basically the same as Example 1, and the differences lie in that: in step A of this example, the step of "then performing reduction annealing at 1025°C for 35 min in a mixed gas atmosphere of Ar₂ and H₂ (with a volume ratio of 2:1)" is example 1 is replaced by a step of "then performing reduction annealing at 1025°C for 35 min in Ar₂".

### Comparative Example 1

This comparative example is basically the same as Example 1, and the differences lie in that: secondary oxygenation is not performed during the preparation of the composite conductor in this comparative example. Specifically, method in this comparative example includes:

Step A: exposing a copper foil to air, and treating it at 105°C for 3 h by using an electric heating plate to obtain pre-oxidized copper foil. Followed by placing the pre-oxidized copper foil in a quartz boat, pushing it into a CVD tube furnace and vacuum pumping to 0.1 Pa and keeping for 2 min; then performing reduction annealing at 1025°C for 35 min in a mixed gas atmosphere of Ar₂ and H₂ (with a volume ratio of 2:1).

The pre-oxidized copper foil includes a metal substrate and a metal oxide layer on one surface of the metal substrate. The metal oxide layer includes a first metal oxide layer bonded to the metal substrate and a second metal oxide layer bonded to the surface of the first metal oxide layer away from the metal substrate. The metal substrate includes copper. The first metal oxide layer includes copper oxide and cuprous oxide. The second metal oxide layer includes copper oxide. The thickness of the first metal oxide layer is 0.25µm. The thickness of the second metal oxide layer is 0.325 µm. The mass ratio of copper oxide to cuprous oxide in the first metal oxide layer is 0.03:1.

The oxygen content in the pre-oxidized copper foil obtained after treating by using an electric heating plate at 105°C for 3 h is about 225 ppm. The oxygen content in the pre-oxidized copper foil after reduction annealing is about 60 ppm.

Step B: then introducing CH₄ gas (with a flow rate of 20 sccm) into the system for 60 min, then stopping introducing CH₄ gas, and opening the cover the furnace to allow it to be cooled naturally to room temperature, thus obtaining the composite conductor

The conductivity (IACS)and mechanical properties of the composite conductor 100 obtained in Examples 1-11 and Comparative Example 1 were tested, and the test results are shown in Table 1 below.

**Table 1**

| | Thickness of metal substrate /µm | Thickness of transition layer/µm | Thickness of graphene layer/µm | Mass ratio of copper to the first graphene in transition layer | Average sheet size of first graphene/ µm | average sheet size of second graphene/µm | Conductivity (IACS) | Vickers hardness HV_{0.2} |
|---|---|---|---|---|---|---|---|---|
| Example 1 | 30 | 0.57 | 2 | 25:1 | 0.1 | 6 | 121% | 57.1 |
| Example 2 | 30 | 0.11 | 2 | 0.5:1 | 0.01 | 2 | 119% | 56.0 |
| Example 3 | 30 | 1.00 | 2 | 50:1 | 0.05 | 4 | 120.5% | 56.8 |
| Example 4 | 30 | 0.57 | 2 | 25:1 | 0.08 | 5 | 120.8% | 56.9 |
| Example 5 | 30 | 0.57 | 2 | 25:1 | 0.08 | 5.5 | 120.7% | 56.9 |
| Example 6 | 30 | 0.57 | 1.5 | 10:1 | 0.05 | 4.8 | 119% | 56.3 |
| Example 8 | 30 | 0.57 | 3 | 40:1 | 0.09 | 5 | 120.9% | 57.0 |
| Example 8 | 30 | 0.57 | 2.2 | 25:1 | 0.1 | 6 | 121% | 57.1 |
| Example 9 | 30 | 0.57 | 2.3 | 25:1 | 0.1 | 6 | 120.8% | 57.0 |
| Example 10 | 30 | 0.57 | 2 | 25:1 | 0.1 | 6 | 120.9% | 56.9 |
| Example 11 | 30 | 0.57 | 2 | 25:1 | 0.06 | 2.1 | 117.2% | 56.1 |
| Comparative Example 1 | 30 | 0.57 | 2 | 25:1 | 0.01 | 1.5 | 114% | 54 |
| Copper | 30 | / | / | / | / | / | 100% | 53.2 |

It can be known from Table 1 that:
The conductivity of each of the composite conductors 100 in Examples 1 to 11 is greater than 119%, and the highest conductivity can reach 121%, which is significantly improved compared to the conductivity of copper (100%) and the conductivity of the composite conductor in Comparative Example 1. It can be seen that the composite conductor 100 obtained in the present disclosure has superior conductivity.

The Vickers hardness of each of the composite conductors 100 in Examples 1-11 is greater than 56.0, indicating that the composite conductor 100 obtained in the present disclosure has strong hardness.

The technical solutions provided by embodiments of the present disclosure have been described in detail above. The principles and embodiments of the present disclosure have been described with reference to specific examples, and the description of the above examples is merely intended to aid in the understanding of the method of the present disclosure and its core idea. At the same time, changes may be made by those skilled in the field to both the specific embodiments and the scope of present disclosure in accordance with the teachings of the present disclosure. In view of the foregoing, the content of the present specification should not be construed as limiting the disclosure.

## Claims

1. A method for preparing a composite conductor, comprising:
A. providing an initial metal substrate, and subjecting the initial metal substrate to oxidizing treatment to obtain a pre-oxidized metal substrate, the pre-oxidized metal substrate comprises a metal substrate and a metal oxide layer disposed on at least one surface of the metal substrate, the metal oxide layer comprises a first metal oxide layer bonded to the metal substrate and a second metal oxide layer bonded to a surface of the first metal oxide layer away from the metal substrate, the metal substrate comprises a first metal, the first metal oxide layer comprises a metal oxide and a metal suboxide, the second metal oxide layer comprises the metal oxide, and a mass ratio of the metal oxide to the metal suboxide in the first metal oxide layer is in a range of (0.001~0.05):1;
B. subjecting the pre-oxidized metal substrate to annealing treatment in a reducing atmosphere, an oxygen content in the pre-oxidized metal substrate before the annealing treatment in the reducing atmosphere ranges from 150 ppm to 300 ppm, and an oxygen content in the pre-oxidized metal substrate after the annealing treatment in the reducing atmosphere ranges from 20 ppm to 100 ppm; followed by placing the pre-oxidized metal substrate in a deposition chamber; and introducing a carbon source into the deposition chamber at a first temperature for a period of time;
C. stopping introducing the carbon source, and introducing an oxygen-containing gas for a period of time, followed by stopping introducing the oxygen-containing gas, and introducing the carbon source; and
D. repeating the step C for a total of n times to obtain the composite conductor, wherein n is an integer greater than or equal to 0.

2. The method as claimed in claim 1, wherein a material of the initial metal substrate comprises one or more of a metal element and an alloy, the metal element comprises one or more of Cu and Al, and the alloy comprises one or more of a copper-nickel alloy, a copper-silver alloy, and a copper-zinc alloy.

3. The method as claimed in claim 2, wherein,
the initial metal substrate comprises a first initial metal substrate, a material of the first initial metal substrate comprises one or more of a metal element and an alloy; the metal element comprises one or more of Cu and Al; and the alloy comprises one or more of a copper-nickel alloy, a copper-silver alloy, and a copper-zinc alloy; or
the initial metal substrate comprises the first initial metal substrate and a second initial metal substrate disposed on a surface of the first initial metal substrate, a material of each of the first initial metal substrate and the second initial metal substrate comprises one or more of a metal element and an alloy, the metal element comprise one or more of Cu and Al, and the alloy comprises one or more of a copper-nickel alloy, a copper-silver alloy, and a copper-zinc alloy, and the material of the first initial metal substrate is same as or different from that of the second initial metal substrate.

4. The method as claimed in claim 1, wherein,
the first metal comprises one or more of a metal element and an alloy, the metal element comprises one or more of Cu and Al, and the alloy comprises one or more of a copper-nickel alloy, a copper-silver alloy, and a copper-zinc alloy; and/or
the metal oxide comprises one or more of copper oxide, aluminum oxide, nickel oxide, nickel tetroxide, nickel trioxide, silver oxide, and zinc oxide; and/or
the metal suboxide comprises cuprous oxide.

5. The method as claimed in claim 1, wherein,
the carbon source comprises one or more of methane, natural gas, acetylene, and propane; and/or
the oxygen-containing gas comprises air, oxygen, and an inert gas containing oxygen.

6. The method as claimed in claim 1, wherein,
the initial metal substrate comprises a metal particle, a metal foil, or a metal wire; and/or
the initial metal substrate comprises a metal particle, a metal foil, or a metal wire.

7. The method as claimed in claim 1, wherein,
in the pre-oxidized metal substrate, the metal oxide layer covers 99.6% to 100% of a surface of the metal substrate; and/or
a thickness of the first metal oxide layer ranges from 0.06 µm to 0.45 µm; and/or
a thickness of the second metal oxide layer ranges from 0.05 µm to 0.6 µm; and/or
a ratio of the thickness of the first metal oxide layer to the thickness of the second metal oxide layer is in a range of (0.1 to 9):1; and/or
a thickness of the metal oxide layer ranges from 0.1 µm to 1 µm.

8. The method as claimed in claim 1, wherein,
the first temperature ranges from 1000°C to 1055°C; and/or
a gas flow rate of the carbon source ranges from 3 sccm to 40 sccm; and/or
a flow rate of the oxygen-containing gas ranges from 3 sccm to 40 sccm; and/or
a total time for introducing the carbon source ranges from 60 min to 90 min; and/or
the annealing treatment is performed at a temperature ranging from 1000°C to 1055°C for a time period ranging from 30 min to 40 min.

9. The method as claimed in claim 1, wherein,
the period of time for introducing the carbon source for each time is 15~30 min; and/or
the period of time for introducing the carbon source for each time is different, and the period of time for introducing the carbon source for a previous time is (1/3 to 1/2) times that for a next time, and the period of time for introducing the carbon source for a first time is 30~40 min.

10. The method as claimed in claim 1, wherein the subjecting the initial metal substrate to oxidizing treatment comprises: placing the initial metal substrate in an oxygen-containing atmosphere, and performing heat-treating at a second temperature for a period of time t1.

11. The method as claimed in claim 10, wherein,
the oxygen-containing atmosphere comprises air, oxygen, an oxygen-containing inert gas; and/or
the second temperature ranges from 60°C to 150°C, and the period of time t1 ranges from 1 h to 5 h.

12. The method as claimed in claim 1, wherein after obtaining the pre-oxidized metal substrate, the method further comprises: placing the pre-oxidized metal substrate in a sealed environment, vacuum pumping until a vacuum degree is less than 0.1 Pa, and keeping for a period of time t3, wherein the period of time t3 ranges from 2 min to 10 min.

13. The method as claimed in claim 1, wherein,
a reducing gas in the reducing atmosphere comprises hydrogen; and/or
the reducing atmosphere further comprises a second inert gas, second inert gas comprises one or more of nitrogen, helium, argon, and xenon, and a volume ratio of the second inert gas to the reducing gas in the reducing atmosphere is in a range of (0.5~2):1.

14. The method as claimed in claim 1, wherein a protective gas is introduced when introducing the carbon source.

15. The method as claimed in claim 14, wherein,
the protective gas comprises one or more of nitrogen, helium, argon, and xenon; and/or
a flow rate of the protective gas ranges from 0 to 1000 sccm.

16. The method as claimed in claim 1, wherein a reducing gas is introduced when introducing the carbon source.

17. The method as claimed in claim 16, wherein,
the reducing gas comprises hydrogen; and/or
a flow rate of the reducing gas ranges from 5 sccm to 500 sccm.

18. A composite conductor, wherein the composite conductor is prepared by the method as claimed in any one of claims 1 to 17, the composite conductor comprises the metal substrate, a transition layer disposed on at least one surface of the metal substrate, and a graphene layer disposed on a surface of the transition layer away from the metal substrate, wherein the metal substrate comprises the first metal, the transition layer comprises a second metal and a first graphene, the graphene layer comprises a second graphene, and an average sheet size of the first graphene is less than an average sheet size of the second graphene.

19. The composite conductor as claimed in claim 18, wherein,
the first metal comprises one or more of the metal element and the alloy, the metal element comprises one or more of Cu and Al, and the alloy comprises one or more of the copper-nickel alloy, the copper-silver alloy, and the copper-zinc alloy; and/or
the second metal comprises one or more of the metal element and the alloy, wherein the metal element comprises one or more of Cu and Al, and the alloy comprises one or more of the copper-nickel alloy, the copper-silver alloy, and the copper-zinc alloy; and/or
the average sheet size of the first graphene ranges from 0.01 µm to 0.1 µm; and/or
the average sheet size of the second graphene ranges from 2 µm to 6 µm; and/or
in the transition layer, a mass ratio of the metal to the first graphene is in a range of (0.5~50):1; and/or
the metal substrate comprises the metal particle, the metal wire, or the metal foil; and/or
a thickness of the transition layer ranges from 0.1 µm to 1 µm; and/or
a thickness of the graphene layer ranges from 0.335 nm to 3 nm; and/or
a conductivity of the composite conductor ranges from 87% to 121%.

20. An application of the composite conductor as claimed in any one of claims 18-19 as a wire/cable or an electrical contact.
